# EUROPEAN PATENT SPECIFICATION

(11) **EP 0 450 199 B1**
(45) Date of publication and mention of the grant of the patent: **23.08.1995**
(21) Application number: 90200801.0
(22) Date of filing: 04.04.1990
(51) Int. Cl.: B41N 1/14

(54) **Water developable diazo based lithographic printing plate**
Wasserentwickelbare lithographische Diazo-Druckplatte
Planche d'impression lithographique diazo développable dans l'eau

(43) Date of publication of application: 09.10.1991
(73) Proprietor: AGFA-GEVAERT naamloze vennootschap, 2640 Mortsel (BE)
(72) Inventor: Vermeersch, Joan Triphon, B 9800 Deinze (BE); Coppens, Paul Jozef, B 2300 Turnhout (BE); Hauquier, Guido Isodoor, B 2630 Aartselaar (BE)

(56) References cited:
- DE-A- 2 002 562
- GB-A- 1 419 512
- US-A- 2 532 866
- US-A- 3 386 850
- US-A- 4 575 465

## Description

The present invention relates to a diazo sensitized lithographic printing plate which is water developable.

Lithography is the process of printing from specially prepared surfaces, some areas of which are capable of accepting lithographic ink, whereas other areas, when moistened with water, will not accept the ink. The areas which accept ink form the printing image areas and the ink-rejecting areas form the background areas.

In the art of photolithography, a photographic material is made imagewise receptive to oily or greasy inks in the photo-exposed (negative-working) or in the non-exposed areas (positive-working) on a hydrophilic background.

In the production of common lithographic printing plates, also called surface litho plates or planographic printing plates, a support that has affinity to water or obtains such affinity by chemical treatment is coated with a thin layer of a photosensitive composition. Coatings for that purpose include light-sensitive polymer layers containing diazo compounds, dichromate-sensitized hydrophilic colloids and a large variety of synthetic photopolymers.

Particularly diazo-sensitized systems are widely used. These systems have been extensively reviewed by Kosar J. in "Light-Sensitive Systems", Wiley, New York, 1965, Chapter 7.

A generally used negative-working diazo-sensitized system is based on the capability of diazo compounds to harden a polymer when exposed to ultraviolet and blue radiation. Diazo compounds which have been used for the preparation of lithographic printing plates based on their hardening properties are e.g. diazonium salts whose photolysis products can harden polymers (natural colloids or synthetic resins) directly and diazonium polymers. Although polymers containing diazonium groups have a large structure they remain water soluble owing to the presence of the ionic diazonium groups. When these groups are destroyed by exposure to light an insoluble resin is formed. Particularly useful diazonium polymers are the condensation products of a carbonyl compound, e.g. an aldehyde, such as formaldehyde, with a diazonium salt of e.g. a p-aminodiphenylamine. These condensation products are usually designated diazo resins. In these systems a polymeric binder is optionally added to the diazo resin coating.

Several types of supports can be used for the manufacturing of a diazo-sensitized lithographic printing plate. Common supports are metal supports like Al or Zn, polyester film supports and paper bases. These supports, if not sufficient hydrophilic by themselves, are first coated with a hydrophilic layer to form the hydrophilic background of the printing plate and a top layer containing the diazo compound is then applied (see for example DE-P-1900469, DE-P-2030634 and US-P-3971660).

It is known to use as hydrophilic layer in these systems a layer containing polyvinyl alcohol and hydrolyzed tetraethyl orthosilicate and preferably also silicium dioxide and/or titanium dioxide as described in e.g. GB-P-1419512, FR-P-2300354, US-P-3971660 and 4284705. This hydrophilic layer is overcoated with a light-sensitive layer containing a diazonium salt or a diazo resin in a polymeric binder.

Upon image-wise exposure of the light-sensitive layer the exposed image areas become water insoluble and the unexposed areas remain water soluble. The plate is then developed with water to remove the diazonium salt or diazo resin in the unexposed areas.

However it has been found that the dissolving power of water is insufficient to remove all the diazo in the non-exposed areas. The art has therefore long sought for a plain water-developable diazo-sensitized plate without leaving residual diazo in the non-exposed areas.

US-A-2532866 discloses the use of a dibasic acid to avoid colloidal scumming in a lithographic printing plate. The lithographic printing plate has a steel support and is provided with a water swellable hydrophilic layer comprising e.g. polyvinyl alcohol.

DE-A-2002562 discloses the use of phosphates in a lithographic base consisting of a paper provided with two layers. The phosphate reacts with a multi-valent metal ion to form a voluminous reaction product filling the pores in the layer closest to the support and the pores at the interface between the two layers.

US-A-3386850 discloses the use of phytic acid in a barrier layer of a lithographic printing plate to increase the hydrophilicity of the background and thereby preventing scumming.

It is an object of the present invention to provide a lithographic printing plate which can be processed with plain water to remove the diazo compound in the non-exposed areas.

Other objects will become apparent from the description hereinafter.

According to the present invention a presensitized imaging element suitable for making a diazo based lithographic printing plate is provided. said imaging element comprising on a support, a hydrophilic layer containing in homogeneously distributed state throughout the entire layer a hydrophilic (co)polymer or (co)polymer mixture and a tetraalkyl orthosilicate crosslinking agent and a light-sensitive diazo resin or diazonium salt in said hydrophilic layer or in a separate layer on top thereof and further a compound to prevent scumming being present in said hydrophilic layer and/or in said separate layer, said compound to prevent scumming being a compound as defined in claim 1.

Examples of compounds that prevent scumming in the non-exposed areas suitable for use in the present invention include phosphonic acids such as phytic acid and salts thereof, derivatives of phosphoric acid and their salts, hexametaphosphates, polymers containing phosphonic acid groups and salts thereof, ammonium salts of substituted amines containing alkyl and/or aryl groups attached to the nitrogen and polymers containing these ammonium groups. Particularly preferred are phytic acid, sodium dihydrogen phosphate or poly(trimethyl(4-vinylbenzyl)ammonium chloride).

As hydrophilic (co)polymers in said first hydrophilic layer one may use, for example, homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is the same as or higher than the hydrophilicity of polyvinyl acetate hydrolyzed to at least an extent of 60 percent by weight, preferably 80 percent by weight.

Examples of tetraalkyl orthosilicate crosslinking agents are hydrolyzed tetraethyl orthosilicate and hydrolyzed tetramethyl orthosilicate.

Said first hydrophilic layer in the presensitized imaging element preferably also contains substances that increase the mechanical strength and the porosity of the layer. For this purpose colloidal silica may be used. The colloidal silica employed may be in the form of any commercially available water-dispersion of colloidal silica for example having an average particle size up to 40 nm, e.g. 20 nm. In addition inert particles of larger size than the colloidal silica can be added e.g. silica prepared according to Stöber as described in J. Colloid and Interface Sci., Vol. 26, 1968, pages 62 to 69 or alumina particles or particles having an average diameter of at least 100 nm which are particles of titanium dioxide or other heavy metal oxides. By incorporating these particles the surface of the layer is given a uniform rough texture consisting of microscopic hills and valleys, which serve as storage places for water in background areas.

The amount of tetraalkyl orthosilicate crosslinking agent is at least 0.2 parts by weight per part by weight of hydrophilic (co)polymer, preferably between 0.5 and 5 parts by weight, preferably 1.5 part by weight.

The amounts of the other components in the hydrophilic layer of the imaging element of the present invention are not very critical and may be varied provided the physical characteristics and shelf life of the layer are not drastically impaired.

Said diazo resin or diazonium salt may be present in the hydrophilic layer but is preferably present in a separate hydrophilic layer e.g. of polyvinylalcohol, wherein the said layer preferably contains dispersed water-insoluble polymers.

The aqueous dispersion of the water insoluble polymer from which said separate layer is coated is preferably cationic or nonionic either e.g. as a result of an emulsifier or by having the cationic or nonionic group linked to the polymer. The water insoluble polymer is preferably a solid particulate having a size in the range of about 100.10⁻¹⁰m to 1 »m (micron) in diameter and does not form a film below 30 °C. In general, any polymer which carries a cationic or nonionic group or which can be formulated into an emulsion using a cationic or nonionic emulsifier can be employed in the present invention. Suitable polymers include homopolymers and copolymers of styrene, methylacrylate, ethylacrylate, butylacrylate, methylmethacrylate, ethylmethacrylate, butyl methacrylate, vinyl acetate, vinyl chloride, vinylidene chloride, butadiene, methyl styrene, vinyl toluene, dimethylaminoethyl acrylate, acrylic acid, methacrylic acid, isoprene, chloroprene, maleic anhydride, ethylene glycol acrylates such as polyethylene glycol acrylate, halogenated vinyl aromatics such as chlorostyrene and bromostyrene, methylvinyl ether, vinyl pyrrolidone, polyurethane and the like.

Among the cationic and nonionic emulsifiers which can be used in the present invention are: ammonium salts of substituted amines containing alkyl and/or aryl groups attached to the nitrogen, alkyl or aryl sulfonium salts, alkyl and alkyl-aryl polyethers, cationic or nonionic fluorosurfactants and polyoles.

Examples of low-molecular weight diazonium salt for use in the present invention include: benzidine tetrazoniumchloride, 3,3'-dimethylbenzidine tetrazoniumchloride, 3,3'-dimethoxybenzidine tetrazoniumchloride, 4,4'-diaminodiphenylamine tetrazoniumchloride, 3,3'-diethylbenzidine tetrazoniumsulfate, 4-aminodiphenylamine diazoniumsulfate, 4-aminodiphenylamine diazoniumchloride, 4-piperidino aniline diazoniumsulfate, 4-diethylamino aniline diazoniumsulfate and oligomeric condensation products of diazodiphenylamine and formaldehyde.

Examples of diazo resins usefull in the present invention include condensation products of an aromatic diazonium salt as the light-sensitive substance. Such condensation products are known and are described, for example, in German Pat. no. 1214086. They are in general prepared by condensation of a polynuclear aromatic diazonium compound, preferably of substituted or unsubstituted diphenylamine-4-diazonium salts, with active carbonyl compounds, preferably formaldehyde, in a strongly acid medium.

Said presensitized imaging element advantageously contains water-soluble dyes such as rhodamines, sudan blue, methylen blue, eosin or trifenylmethane dyes such as crystal violet, victoria pure blue, malachite green, methylviolet and fuchsin.

Said presensitized imaging element preferably also contains dye pigments which are essentially water insoluble.

The thickness of the separate hydrophilic layer in the material of this invention may vary in the range of 0.2 to 25 um and is preferably 1 to 10 um.

The thickness of the light-sensitive layer in the material of this invention may vary in the range of 0.1 to 10 um and is preferably between 0.5 and 2.5 um.

The coating composition of the invention is coated using any conventional coating method.

According to a particularly advantageous embodiment an aqueous solution containing TiO₂ from 5 to 40 % by weight, polyvinyl alcohol from 0.5 to 20 % by weight, hydrolyzed tetramethyl orthosilicate from 0.2 to 20 % by weight and an amount of sodium dihydrogenphosphate from 0.1 to 15 % by weight was coated on a polyester (coated with a hydrophilic adhesion layer) support. To this element was then applied an aqueous solution containing polymethylmethacrylate particles (particle diameter of 60 nm ), stabilized with cetyltrimethyl ammonium bromide, from 1 to 10 % by weight, polyvinyl alcohol from 1 to 10 % by weight, heliogen blue (BASF) from 0.01 to 0.5 % by weight, flexoviolet (BASF) from 0.01 to 0.5 % by weight and the condensation product of difenyl amine diazonium salt with formaldehyde in an amount of 0.5 to 10 % by weight.

Various supports may be used for the lithographic coating of this invention provided it has been treated to provide a surface to which the hydrophilic layer can be applied and adheres. Examples of such supports are photographic film bases e.g. substrated polyethylene terephthalate film, cellulose acetate film, plastics having a metal layer or deposit thereon, a metal support, e.g. aluminium and polyolefin (e.g. polyethylene) coated paper, the polyolefin surface of which may have been subjected to a corona discharge to improve the adherence of the lithographic coating.

The exposure of the imaging element used in the present invention advantageously proceeds with ultraviolet light optionally in combination with blue light in the wavelength range of 250 to 500 nm. Useful exposure sources are high or medium pressure halogen mercury vapour lamps, e.g. of 1000 W.

Since most lithography is done by the offset process, the imaging element is exposed in such a way that the image obtained thereon is right reading. The exposure may be an exposure using optics or a contact exposure.

The diazo resin or diazonium salts are converted upon exposure from water soluble to water insoluble (due to the destruction of the diazonium groups) and additionally the photolysis products of the diazo may induce an advancement in the level of crosslinking of the polymeric binder or diazo resin, thereby selectively converting the surface, in an image pattern, from water soluble to water insoluble. The unexposed areas remain unchanged, i.e. water soluble.

When mounted on a printing press the printing plate is first washed with an aqueous fountain solution. To prevent this fountain solution from being contaminated by residual non-exposed diazo which are water soluble, the unexposed diazo resin or diazonium salt should be removed from the printing plate before mounting it on a printing press. This removal can be achieved by washing the imaging element with plain water.

The following examples illustrate the present invention without being limited thereto. The percentages given are by weight unless otherwise stated.

### EXAMPLE 1 (comparison)

To 418 g of a dispersion containing 21.5 % TiO₂ (average particle size 0.3 to 0.5 um) and 2.5 % polyvinyl alcohol in deionized water were subsequently added, while stirring, 220 g of a 5 % polyvinyl alcohol solution in water, 95 g of a hydrolyzed 22 % tetramethyl orthosilicate emulsion in water and 22 g of a 10 % solution of a wetting agent. To this mixture was then added 245 ml of deionized water and the pH was adjusted to pH=4.

To 80 g of a 20 % dispersion of polymethylmethacrylate ( particle diameter of 60 nm ) stabilized with cetyltrimethylammonium bromide in deionized water were subsequently added, while stirring, a 240 g of a 5 % solution of polyvinyl alcohol in water, 60 g of a 7.5 % dispersion of heliogen blue (BASF) in water and 20 g of a 0.63 % solution of flexoviolet (BASF) in water. 80 g of a 15 % solution of the condensation product of difenyl amine diazonium salt and formaldehyde in water was then slowly added. Finally 10 g of a wetting agent and 510 ml of water were added.

After mixing, the first dispersion was coated on a polyester (coated with a hydrophilic adhesion layer) support to a wet coating thickness of 55 g/m² and dried at 30 °C. To this resulting element the second dispersion was applied to a wet coating thickness of 35 g/m² and dried at 30 °C.

The resulting imaging element was exposed through a mask to a high pressure halogen mercury vapour lamp of 1000 W at a distance of 70 cm for 10 minutes.

Subsequently the imaging element was developed in a Polychrome PC28 E PS-processor containing plain water at 25°C.

A lithographic plate was thus obtained which was used on an AB-Dick 360 printer using a conventional fountain solution and oleophilic lithographic inks. The density obtained in the none-image areas on the 26th print was 1.04.

### EXAMPLE 2

To 418 g of a dispersion containing 21.5 % TiO₂ (average particle size 0.3 to 0.5 um) and 2.5 % polyvinyl alcohol in deionized water were subsequently added, while stirring, 220 g of a 5 % polyvinyl alcohol solution in water, 95 g of a hydrolyzed 22 % tetramethyl orthosilicate emulsion in water, 40 g of a 14 % solution of sodium dihydrophosphate and 22 g of a 10 % solution of a wetting agent. To this mixture was then added 205 ml of deionized water and the pH was adjusted to 4.

After mixing, the resulting dispersion was coated on a polyester (coated with a hydrophilic adhesion layer) support and dried at 30 °C. To this element the second solution of example one was applied and dried at 30 °C. Both layers were coated in a same amount as example 1.

The obtained imaging element was exposed and processed as described in example 1. The thus obtained lithographic plate was used as described in example 1. The measured density in the non-image areas after the 26th print was 0.00.

### EXAMPLE 3

To 418 g of a dispersion containing 21.5 % TiO₂ (average particle size 0.3 to 0.5 um) and 2.5 % polyvinyl alcohol in deionized water were subsequently added, while stirring, 220 g of a 5 % polyvinyl alcohol solution in water, 95 g of a hydrolyzed 22 % tetramethyl orthosilicate emulsion in water, 80 g of a 17.5 % solution of poly(trimethyl(4-vinylbenzyl)ammonium chloride) and 22 g of a 10 % solution of a wetting agent. To this mixture was then added 165 ml of deionized water and the pH was adjusted to 4.

After mixing, the resulting dispersion was coated on a polyester (coated with a hydrophilic adhesion layer) support and dried at 30 °C. To this element the second solution of example one was applied and dried at 30 °C. Both layers were coated in a same amount as example 1.

The imaging element was exposed and processed as described in example 1. The thus obtained lithographic plate was used as described in example 1. The measured density in the non-image areas after the 26th print was 0.01.

### EXAMPLE 4

To 418 g of a dispersion containing 21.5 % TiO₂ (average particle size 0.3 to 0.5 um) and 2.5 % polyvinyl alcohol in deionized water were subsequently added, while stirring, 220 g of a 5 % polyvinyl alcohol solution in water, 95 g of a hydrolyzed 22 % tetramethyl orthosilicate emulsion in water, 40 g of a 17.5 % solution of phytic acid and 22 g of a 10 % solution of a wetting agent. To this mixture was then added 205 ml of deionized water and the pH was adjusted to 4.

After mixing, the resulting dispersion was coated on a polyester (coated with a hydrophilic adhesion layer) support and dried at 30 °C. To this element the second solution of example one was applied and dried at 30 °C. Both layers were coated in a same amount as example 1.

The obtained imaging element was exposed and processed as described in example 1. The thus obtained lithographic plate was used as described in example 1. The measured density in the non-image areas after the 26th print was 0.00.

## Claims

1. A presensitized imaging element for a lithographic printing plate comprising on a support, a hydrophilic layer containing in homogeneously distributed state throughout the entire layer a hydrophilic (co)polymer or (co)polymer mixture and a tetraalkyl orthosilicate crosslinking agent and a light-sensitive diazo resin or diazonium salt in said hydrophilic layer or in a separate layer on top thereof and further a compound to prevent scumming being present in said hydrophilic layer and/or in said separate layer,
characterized in that said compound to prevent scumming is a phosphonic acid or salts thereof, a polymer containing phosphonic acid groups or salts thereof, a phosphoric acid and derivatives or salts thereof, an ammonium salt of a substituted amine containing alkyl and/or aryl groups attached to the nitrogen or a polymer containing these ammonium groups.

2. A presensitized imaging element according to claim 1 characterized in that said compound to prevent scumming is phytic acid, sodium dihydrogen phosphate or poly(trimethyl(4-vinylbenzyl)ammonium chloride).

3. A presensitized imaging element according to any of the preceding claims characterized in that the light-sensitive diazo resin or diazonium salt is contained in a separate layer comprising a dispersion of a water insoluble (co)polymer in an aqueous solution of polyvinylalcohol.

4. A presensitized imaging element according to claim 3 characterized in that said water insoluble (co)polymer is polymethylmethacrylate.

5. A presensitized imaging element according to any of the preceding claims characterized in that said hydrophilic (co)polymer or (co)polymer mixture has a hydrophilicity which is the same as or higher than the hydrophilicity of polyvinyl acetate hydrolyzed to at least an extent of 60 percent by weight.

6. A presensitized imaging element according to any of the preceding claims characterized in that said hydrophilic (co)polymer is polyvinylalcohol or polyhydroxyethyl acrylate or polyacryl amide.

7. A presensitized imaging element according to any of the preceding claims characterized in that the tetraalkyl orthosilicate crosslinking agent is hydrolyzed tetraethyl orthosilicate or hydrolyzed tetramethyl orthosilicate.

8. A presensitized imaging element according to any of the preceding claims characterized in that said diazo resin is a condensation product of diphenyl amine diazonium salt and formaldehyde.

9. A presensitized imaging element according to any of the preceding claims characterized in that said first hydrophylic layer also contains (a) substance(s) that increase(s) the mechanical strength and the porosity of the layer.

10. A presensitized imaging element according to claim 9 characterized in that said substance(s) that increases the mechanical strength and the porosity of the layer is (are) colloidal silica and/or particles of titanium dioxide or an other heavy metal oxide.

11. A method for making a lithographic printing plate comprising the steps of image-wise exposing an imaging element as defined in any of claims 1 to 10 and developing said imaging element by means of plain water.

## Patentansprüche

1. Ein vorbeschichtetes, bilderzeugendes Element für eine lithografische Druckplatte, das auf einem Träger eine hydrophile Schicht umfaßt, die ein hydrophiles (Co)polymeres oder ein hydrophiles (Co)polymerisatgemisch in homogen über die Gesamtschicht verteiltem Zustand und ein Tetraalkylorthosilikat-Vernetzungsmittel und ein lichtempfindliches Diazoharz oder Diazoniumsalz in der hydrophilen Schicht oder in einer darauf aufgebrachten getrennten Schicht und weiterhin eine in der hydrophilen Schicht und/oder in der getrennten Schicht befindliche Verbindung zur Vorbeugung gegen Tonen enthält, dadurch gekennzeichnet, daß die Verbindung zur Vorbeugung gegen Tonen eine Phosphonsäure oder Salze davon, ein Phosphonsäuregruppen oder Salze davon enthaltendes Polymeres, eine Phosphorsäure und Abkömmlingen oder Salze davon, ein Ammoniumsalz eines substituierten Amins, das mit dem Stickstoff verknüpfte Alkyl- und/oder Arylgruppen enthält, oder ein Polymeres, das diese Ammoniumgruppen enthält, ist.

2. Ein vorbeschichtetes, bilderzeugendes Element nach Anspruch 1, dadurch gekennzeichnet, daß die Verbindung zur Vorbeugung gegen Tonen Phytinsäure, Natriumdihydrogenphosphat oder Poly[trimethyl(4-vinylbenzyl)ammoniumchlorid] ist.

3. Ein vorbeschichtetes, bilderzeugendes Element nach Anspruch 1 oder 2, dadurch gekennzeichnet, daß das lichtempfindliche Diazoharz oder Diazoniumsalz in einer getrennten Schicht enthalten ist, die eine Dispersion eines wasserunlöslichen (Co)polymeren in einer wäßrigen Polyvinylalkohol-Lösung umfaßt.

4. Ein vorbeschichtetes, bilderzeugendes Element nach Anspruch 3, dadurch gekennzeichnet, daß das wasserunlösliche (Co)polymere Polymethylmethacrylat ist.

5. Ein vorbeschichtetes, bilderzeugendes Element nach irgendeinem der vorstehenden Ansprüche, dadurch gekennzeichnet, daß das hydrophile (Co)polymere oder das hydrophile (Co)polymerisatgemisch die gleiche Hydrophilie wie, oder eine höhere Hydrophilie als die des zu wenigstens 60 Gew.-% hydrolisierten Polyvinylacetats aufweist.

6. Ein vorbeschichtetes, bilderzeugendes Element nach irgendeinem der vorstehenden Ansprüche, dadurch gekennzeichnet, daß das hydrophile (Co)polymere Polyvinylalkohol oder Polyhydroxyethylacrylat oder Polyacrylamid ist.

7. Ein vorbeschichtetes, bilderzeugendes Element nach irgendeinem der vorstehenden Ansprüche, dadurch gekennzeichnet, daß das Tetraalkylorthosilikat-Vernetzungsmittel hydrolysiertes Tetraethylorthosilikat oder hydrolisiertes Tetramethylorthosilikat ist.

8. Ein vorbeschichtetes, bilderzeugendes Element nach irgendeinem der vorstehenden Ansprüche, dadurch gekennzeichnet, daß das Diazoharz ein Kondensationsprodukt von Diphenylamin-Diazoniumsalz und Formaldehyd ist.

9. Ein vorbeschichtetes, bilderzeugendes Element nach irgendeinem der vorstehenden Ansprüche, dadurch gekennzeichnet, daß die erste hydrophile Schicht ebenfalls einen oder mehrere Stoffe enthält, die die mechanische Festigkeit und die Porosität der Schicht erhöhen,

10. Ein vorbeschichtetes, bilderzeugendes Element nach Anspruch 9, dadurch gekennzeichnet, daß dieser Stoff bzw. diese Stoffe, der bzw. die die mechanische Festigkeit und die Porosität der Schicht erhöht bzw. erhöhen, colloidale Kieselerde und/oder Titandioxidteilchen oder Teilchen eines sonstigen Schwermetalloxids ist bzw. sind.

11. Ein Fertigungsverfahren für eine lithografische Druckplatte, das die folgenden Schritte umfaßt : das bildmäßige Belichten eines bilderzeugenden Elements, das irgendeinem der Ansprüche 1 bis 10 entspricht, und das Entwicklen des bilderzeugenden Elements mit Reinwasser.

## Revendications

1. Un élément formateur d'image présensibilisé pour une plaque d'impression lithographique comportant sur un support une couche hydrophile renfermant en état de répartition homogène dans la couche entière un (co)polymère ou un mélange de (co)polymères hydrophiles et un réticulant d'orthosilicate de tétraalkyle et une résine diazoïque ou un sel de diazonium photosensibles dans cette couche hydrophile ou dans une couche séparée au-dessus de celle-ci et, en plus, un composé évitant le graissage contenu dans cette couche hydrophile et/ou dans cette couche séparée, caractérisé en ce que ce composé évitant le graissage est un acide phosphonique ou ses sels, un polymère contenant des groupes acide phosphonique ou ses sels, un acide phosphorique et ses dérivés ou ses sels, un sel d'ammonium d'une amine substituée contenant des groupes alkyle et/ou aryle liés à l'atome d'azote, ou un polymère contenant ces groupes ammonium.

2. Un élément formateur d'image présensibilisé suivant la revendication 1, caractérisé en ce que ce composé évitant le graissage est l'acide phytique, le dihydrogénophosphate de sodium ou le chlorure de poly[triméthyl(4-vinylbenzyl)ammonium].

3. Un élément formateur d'image présensibilisé suivant la revendication 1 ou 2, caractérisé en ce que cette résine diazoïque ou ce sel de diazonium photosensibles sont contenus dans une couche séparée renfermant une dispersion d'un (co)polymère non hydrosoluble dans une solution aqueuse de l'alcool polyvinylique.

4. Un élément formateur d'image présensibilisé suivant la revendication 3, caractérisé en ce que ce (co)polymère non hydrosoluble est le polymétacrylate de méthyle.

5. Un élément formateur d'image présensibilisé suivant l'une quelconque des revendications précédentes, caractérisé en ce que ce (co)polymère ou ce mélange de (co)polymères hydrophiles présentent la même hydrophilie, ou une hydrophilie plus élevée que celle du polyacétate de vinyle hydrolysé à raison d'au moins 60 % en poids.

6. Un élément formateur d'image présensibilisé suivant l'une quelconque des revendications précédentes, caractérisé en ce que ce (co)polymère hydrophile est l'alcool polyvinylique ou le polyacrylate d'hydroxyéthyle ou le polyacrylamide.

7. Un élément formateur d'image présensibilisé suivant l'une quelconque des revendications précédentes, caractérisé en ce que ce réticulant d'orthosilicate de tétraalkyle est l'orthosilicate de tétraéthyle hydrolysé ou l'orthosilicate de tétraméthyle hydrolysé.

8. Un élément formateur d'image présensibilisé suivant l'une quelconque des revendications précédentes, caractérisé en ce que cette résine diazoïque est un produit de condensation du sel de diazonium de la diphénylamine et du formaldéhyde.

9. Un élément formateur d'image présensibilisé suivant l'une quelconque des revendications précédentes, caractérisé en ce que cette première couche hydrophile contient également une ou plusieurs substances qui augmentent la résistance mécanique et la porosité de la couche.

10. Un élément formateur d'image présensibilisé suivant la revendication 9, caractérisé en ce que cette substance qui augmente (ces substances qui augmentent) la résistance mécanique et la porosité de la couche est (sont) la silice colloïdale et/ou des particules de bioxyde de titane ou d'un autre oxyde des métaux lourds.

11. Un procédé pour la confection d'une plaque d'impression lithographique comportant les opérations d'exposition conforme à une image d'un élément formateur d'image conforme à l'une quelconque des revendications 1 à 10 et de développement de cet élément formateur d'image en utilisant de l'eau pure.
